# EUROPEAN PATENT APPLICATION

(11) **EP 1 009 097 A1**
(43) Date of publication of application: **14.06.2000**
(21) Application number: 99650098.9
(22) Date of filing: 21.10.1999
(51) Int. Cl.: H03K 19/003

(54) **Variable driver for reducing overshoot, undershoot, and noise in an output buffer**

(30) Priority: 08.12.1998 US 207862
(71) Applicant: Fairchild Semiconductor Corporation, South Portland, Maine 04106 (US)
(72) Inventor: Morrill, David P., Scarborough, Maine 04074 (US)
(74) Representative: McKeown, Yvonne Mary

(57) **Abstract**

A variable drive output buffer for reducing undershoot, overshoot, and switching noise logic signal transitions. The buffer includes a first driver stage and a second driver stage, each coupled between an input node and an output node. The second driver stage includes a standard pull-up and pulldown transistor pair. The first output driver stage of the circuit is designed to propagate a substantial portion of the signal change before the pull-up or pulldown transistor of the second driver stage is turned on. The first output driver stage charges or discharges a substantial portion of the current associated with the output node so that there is little hard drive left by the time either of the pull-up or pulldown transistor is turned on by the signal change. The first driver stage preferably includes a first transition device in parallel with the pulldown transistor and a second transition device in parallel with the pull-up transistor. A delay stage of the first driver stage propagates the input signal faster than a delay stage of the second driver stage propagates that signal to the pull-up and pulldown transistors.

## Description

### BACKGROUND OF THE INVENTION

### 1. Field of the Invention

The present invention relates to output buffers. In particular, the present invention relates to output buffer circuits for propagating logic signals between integrated circuits. More particularly, the present invention relates to output buffer circuits including pull-up and pulldown transistors used to define a logic potential associated with the output nodes of such buffers.

### 2. Description of the Prior Art

Output buffers are used to transfer electrical signals of desired amplitude and strength. Signal transfers occur by way of buses-interfaces that couple active devices that are either on the same semiconductor-based chip or on different chips. The devices may be located proximate to one another, or they may be some distance from one another. One example of a proximate device interface requiring one or more bus connections is the coupling of one printed circuit board to another within a computing system, such as through a backplane bus. An example of a remote device interface requiring one or more bus connections is the coupling of one computing system to another, such as through a telephone transmission line that is, effectively, a voice/data bus.

Output buffers are used to ensure that electrical signals are transferred as accurately and as quickly as possible. It is often the case, however, that when transmission rates increase, signal accuracy may suffer. In particular, it is well known that rapid signal transmission may be accompanied by signal bounce. That is, the noise or ringing associated with the undershoot and overshoot of a final steady state logic high or logic low signal that occurs in the transition between high and low. The difference in the potentials associated with a high signal and a low signal may be as small as 0.4V or as great as 5V. For Complementary Metal Oxide Semiconductor (CMOS) based logic, for example, a logic high corresponds to a nominal 5.0V potential (for a 5.0V power supply) and a nominal 3.3V potential (for a 3.3V power supply), while a logic low is essentially equivalent to ground (GND) or 0.0V.

The potentials associated with high and low signals described above are idealized values. In fact, highs and lows generally fall within a range of potentials associated with the indicated values. Thus, for a 3.3V supply, a high signal may be supplied at 2.6V, for example, while a low signal may actually be associated with a 0.7V value. As the potentials of the power supplies used to power circuitry move closer to GND, the signal bounce mentioned above takes on greater importance. In particular, the initial oscillation around the ultimate steady state value that occurs when the transition between high and low is triggered may vary enough to generate a false logic signal. The noise swing may be enough to cause a low signal to transition to a high-signal potential and vice-versa, or it may be variable enough that the signal is not clearly at either a high potential or a low potential. Either situation is undesirable. For that reason, it is becoming increasingly important that the transitions between high and low signal occur with less noise than has been previously experienced.

Clearly, unexpected changes in logic values are not desirable. This problem is more likely to occur as transmission rates are increased. Increasing transmission rates enables the transfer of more data in a shorter time period and so is desirable in many respects. However, the gain in increased transmission rate is often undermined by an increase in signal noise. That is, a rapid change in signal level creates an oscillation about the steady state value corresponding to the sudden switching on or off of a transistor. As transistors become increasingly smaller in order to achieve the faster transmission rates of interest, the signal bounce that occurs with the rapid switching often creates reflections in transmission media, such as telephone transmission lines where reflections will cause signal errors. It is therefore important to enable "gentle" switching of buffer circuits so that signal noise, including signal undershoot and overshoot, is reduced.

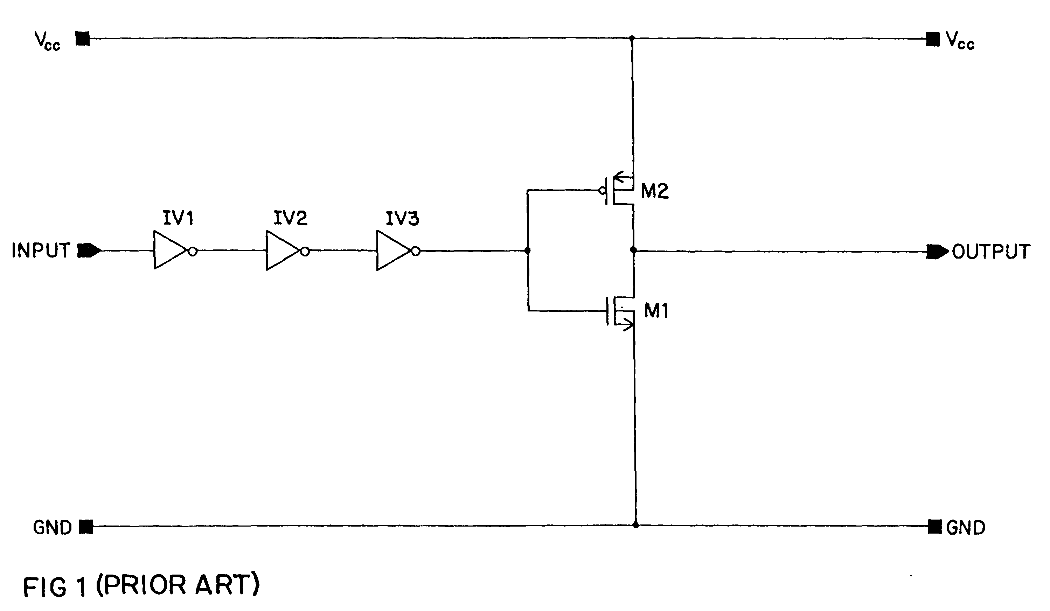

A simplified illustration of a prior-art buffer circuit of the type that exhibits unacceptable signal bounce characteristics is presented in Fig. 1. The buffer circuit includes an input node **INPUT** for receiving an electrical signal, and an output node **OUTPUT** for the transfer of that signal to downstream circuitry. The input node **INPUT** is coupled to a delay device such as inverter **IV1**. The output of the inverter **IV1** is connected either directly, or through optional additional delay inverters **IV2** and **IV3**, to the control nodes of pulldown N-type MOS transistor **M1** and pull-up P-type MOS transistor **M2.** Under steady state **INPUT** conditions, one and only one of transistors **M1** and **M2** is on such that the potential at **OUTPUT** is defined by the state of that stage of the prior-art buffer circuit. When transistor **M2** is on, its gate-source voltage (**Vgs**) exceeds the transistor's threshold voltage (**Vt**). The output node is at a logic high potential equivalent to high-potential power rail **Vcc** less the drain-source voltage (**Vds**) drop associated with transistor **M2**. In the case of MOS transistors, **Vt** is about 0.7V. When transistor **M1** is on, the output node is at a logic low potential equivalent to low-potential power rail **GND**.

Problems arise with the prior-art buffer of FIG. 1 when there is a change in the logic state of the signal at **INPUT**. Specifically, during the transition from a logic high (H) to a logic low (L) for example, the turning off of transistor **M2** and the turning on of transistor **M1** causes a discharging of current from **OUTPUT** through **M1** to low-potential power rail **GND**. This discharge is fairly rapid and hard and creates a potential oscillation (undershoot and overshoot) about the potential associated with **GND**. A similar situation occurs during a L-to-H transition when transistor **M1** is turned off, transistor **M2** is turned on, and node **OUTPUT** is charged to a potential that initially oscillates about the potential associated with high-potential power rail **Vcc**. Clearly, this is an undesirable condition that occurs with every switching of the signal at **INPUT**.

Therefore, what is needed is a buffer circuit that reduces the noise and oscillation associated with signal switching without significantly compromising transmission rate. What is also needed is a buffer circuit that may be tuned to regulate the rate of turn-on of a pull-up or pull-down transistor. Further, what is needed is a "quiet" output buffer circuit that achieves the noted goals without complicated circuitry that takes up valuable layout space.

### SUMMARY OF THE INVENTION

It is an object of the present invention to provide an output buffer circuit with reduced undershoot/overshoot and less noise associated with signal switching. It is an object of the present invention to provide that capability without significantly compromising transmission rate. It is also an object of the present invention to provide an output buffer circuit that may be tuned to regulate the rate of turn-on of a pull-up or a pulldown transistor. It is a further object of the present invention to provide a quiet output buffer circuit that achieves the noted goals without complicated circuitry that takes up valuable layout space.

These and other objectives are achieved in the present invention through the addition of a transition driver stage to the prior-art buffer circuit. During an input signal transition, the transition driver stage is designed to discharge or charge the output node of the buffer circuit substantially completely before the traditional pull-up/pulldown stage of the buffer is activated to complete the transition. This initial current transfer by the transition driver stage results in low signal drive to the pull-up/pulldown stage by the time the appropriate transistor of that stage is activated. Since the drive is low at that time, the output of the buffer circuit essentially "coasts" to the potential associated with the power rail coupled to the switching transistor being activated. The effect is a variable driver buffer circuit that includes the first faster and stronger drive rate associated with the transition driver stage and the second slower diminished driver rate associated with the prior pull-up/pulldown configuration.

In effect, the buffer circuit of the present invention includes a first faster driver stage that is the transition driver stage, and a second slower driver stage that are coupled to the input and the output of the buffer circuit. The first driver stage includes an optional propagation delay stage, a first transition device that is in parallel with the pulldown transistor, and a second transition device that is in parallel with the pull-up transistor. The second driver stage includes a propagation delay stage and the pull-up and pulldown transistors of the prior-art. The delay stages of the two driver stages are coupled to the input and are designed to ensure that a transition input signal is first propagated to the first or the second transition device of the first driver stage, and then to the pull-up/pulldown transistor combination.

During a H-to-L signal switch at the input, the first transition device, which is preferably a PMOS transistor in parallel with the NMOS pulldown transistor, is designed to initially discharge a substantial portion of the current from the output node when that node is at a logic H. During the initial discharging, the pulldown transistor is turned on and takes over the L signal switch as the first transition device turns off. During a L-to-H signal switch at the input, the second transition device, which is preferably an NMOS transistor in parallel with the PMOS pull-up transistor, is designed to initially and substantially provide charging current to the output node when that node is at a logic L. During the initial charging, the pull-up transistor is turned on and takes over the H signal switch as the second transition device turns off.

The configuration of the buffer circuit of the present invention minimizes signal switching noise and reduces undershoot and overshoot potential swings as the final logic signal potential, either **GND** or **Vcc** potential, is approached. The design of the buffer also ensures that the final potential is approached more quickly than otherwise occurs in the prior-art buffer circuit. Additionally, the delay stages of the first and second driver stages may be tailored to select a desirable propagation delay rate for signal switching. This is achieved with minimal effect on layout space.

These and other advantages will become apparent upon review of the following detailed description of the embodiments of the invention, the accompanying drawings, and the appended claims.

### BRIEF DESCRIPTION OF THE DRAWINGS

FIG. 1 is a schematic diagram of a prior-art drive output circuit including a pull-up transistor and a pulldown transistor.

FIG. 2 is a schematic block diagram of the variable drive output buffer circuit of the present invention, showing a pull-up modifying transistor and a pulldown modifying transistor.

FIG. 3 is a schematic diagram of the variable drive output circuit of the present invention, showing a PMOS modifying transistor for pulldown conditions and an NMOS modifying transistor for pull-up conditions.

FIG. 4 is a waveform showing the transition of a H-to-L condition for the variable drive output circuit of the present invention as compared to the drive output transistor of the prior-art shown in FIG. 1

### DETAILED DESCRIPTION OF THE PREFERRED EMBODIMENT OF THE INVENTION

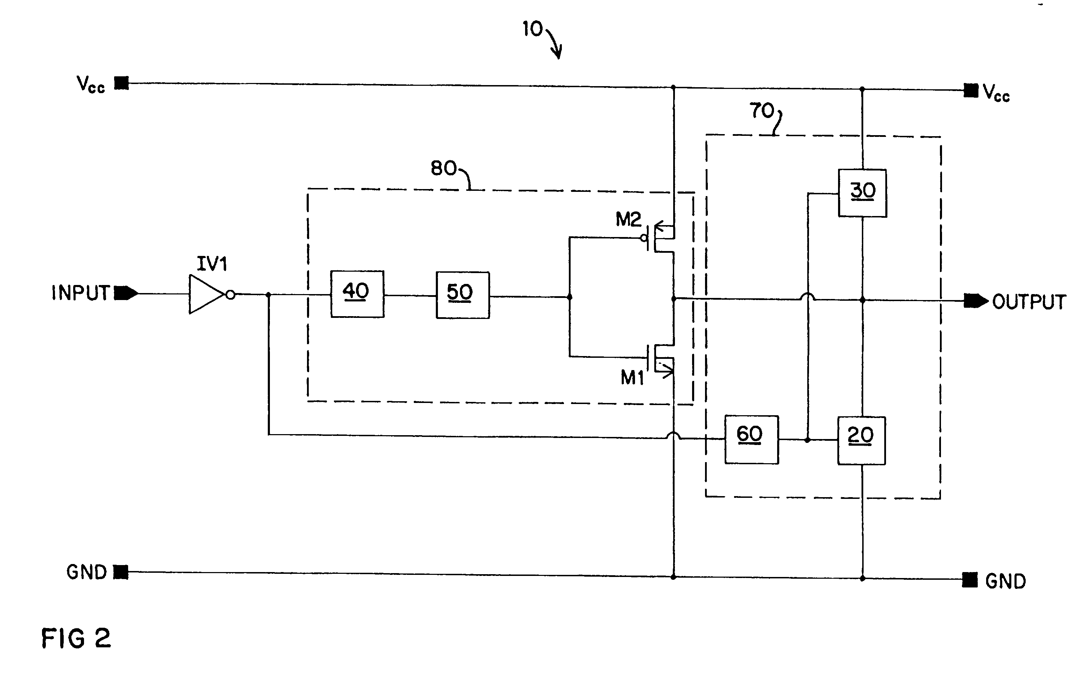

As illustrated in FIG. 2, a variable drive output circuit **10** of the present invention includes a first transition device **20** to modify overshoot and undershoot of a L-to-H logic signal change, and a second transition device **30** to modify overshoot and undershoot of a H-to-L logic signal change. Device **20** modifies the operation of standard pulldown output transistor **M1**, while device **30** modifies the operation of standard pull-up output transistor **M2**. It is to be understood that the circuit **10** of the present invention works for both signal transitions under tristate and non-tri-state conditions. Further, the first transition device **20** or the second transition device **30** may be used independent of the other of those two devices in the event transition smoothing is of interest for one of the two output transistors **M1** and **M2.** Those two transistors, along with optional inverter **IV1**, a first delay stage **40**, a second delay stage **50**, and a third delay stage **60** form the remainder of the components of the circuit **10** of the present invention.

With continuing reference to FIG. 2, the first transition device **20** and the second transition device **30** are preferably controlled by third delay stage **60** that provides one less delay than the delay associated with stages **40** and **50** used to control of operation of standard prior-art pull-up transistor **M1** and pulldown transistor **M2**. It is to be noted that delay stages **40** and **50** may be combined into a single delay stage and that any of the delay stages may be any sort of suitable logic device, including, but not limited to, inverters. Regardless of the configuration of delay stages **40, 50**, and **60**, the signal delay associated with the control of devices **20** and **30** must be less than the signal delay associated with the control of transistors **M1** and **M2.** In that regard, device **20** and device **30** may be coupled directly to input node **INPUT** rather than through stage **60**. Device **20** and device **30** are also coupled to output node **OUTPUT** of the circuit **10.** Device **20** is coupled to high-potential power rail **Vcc** in parallel with transistor **M1,** and device **30** is coupled to low-potential power rail **GND** in parallel with transistor **M2.**

As indicated with regard to the description of delay stages **40, 50**, and **60**, the circuit **10** is designed to ensure that any signal transition at INPUT is first delivered to devices **20** and **30** before delivery to transistors **M1** and **M2**. Thus, for a H-to-L transition, device **20** first substantially, but not completely, discharges current from **OUTPUT** to **GND**. As the potential associated with the **OUTPUT** node approaches the potential associated with **GND**, device **20** begins to turn off and transistor **M1** begins to turn on. Since the current associated with **OUTPUT** is substantially discharged by device **20**, there is little left for **M1** to do other than to complete the signal transition. This is achieved with little signal bounce or noise because the drain-to-source potential **Vds** for **M1** is relatively low by then. Its drive current is also relatively low. It therefore cannot rapidly discharge the current from **OUTPUT** and so the potential at **OUTPUT** effectively coasts to **GND** level. The combination of a strong initial drive by device **20** and a subsequent reduced drive as the desired **GND** potential is reached results in a variable drive system that can be tailored to operate as a function of the configuration and size of the components used to form device **20,** as well as delay stages **40**, **50**, and **60**.

A similar gradual transition is developed for a L-to-H switching in regard to the relationship between device **30** and pull-up transistor **M2.** Specifically, device **30** first substantially, but not completely, transfers current from **Vcc** to **OUTPUT.** As the potential associated with the **OUTPUT** node approaches the potential associated with **Vcc**, device **30** begins to turn off and transistor **M2** begins to turn on. Since the current associated with **Vcc** is substantially transferred to **OUTPUT** by device **30**, there is little left for **M2** to do, other than to complete the signal pull up. This is achieved with little signal bounce or noise because the source-to-drain potential **Vsd** for **M2** is relatively high by then. Its drive current is therefore relatively low. As a result, it cannot rapidly charge **OUTPUT** and so the potential at **OUTPUT** effectively coasts to **Vcc** level. The combination of a strong initial drive by device **30** and a subsequent reduced drive as the desired **Vcc** potential is reached results in a variable drive system that can be tailored to operate as a function of the configuration and size of the components used to form device **30**, as well as delay stages **40**, **50,** and **60**.

In sum, and with reference to FIG. 2, the circuit **10** of the present invention includes a first drive stage **70** including devices **20** and **30**, and optional delay stage **60,** and a second drive stage **80** including pulldown transistor **M1**, pull-up transistor **M2**, and one more delay stages, such as delay stages **40** and **50**. The first drive stage **70** is designed to regulate the potential associated with **OUTPUT** initially and more substantially than second drive stage **80**. Second drive stage **80** takes over and completes the signal transition at **OUTPUT** after stage **70** substantially, but not completely, charges or discharges node **OUTPUT**.

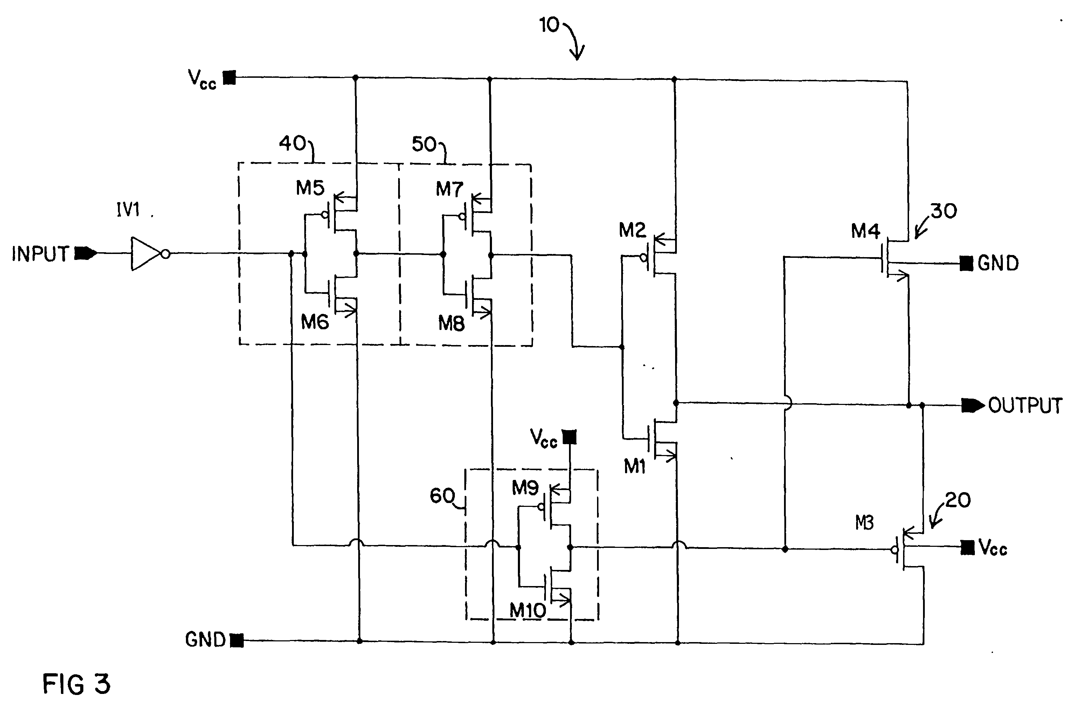

A detailed design of the preferred design of the circuit **10** of the present invention is shown in FIG. 3. The circuit **10** includes optional inverter **IV1** having its input coupled to **INPUT.** First delay stage **40** is preferably an inverter formed of **PMOS** transistor **M5** and **NMOS** transistor **M6**. **M5** has its gate coupled to the output of **IV1**, its source coupled to **Vcc,** and its drain, which is the output of stage **40**, is coupled to the drain of **M6**. **M6** has its gate coupled to the output of **IV1** and its source coupled to **GND**. The output of stage **40** is coupled to the input of second delay stage **50,** which is preferably a second inverter formed of **PMOS** transistor **M7** and **NMOS** transistor **M8**. **M7** has its gate coupled to the output of stage **40**, its source coupled to **Vcc**, and its drain, which is the output of stage **50,** is coupled to the drain of **M8**. **M8** has its gate coupled to the output of stage **40** and its source coupled to **GND**. The output of stage **50** is coupled to the gates of pulldown transistor **M**1 and pull-up transistor **M2**, the outputs of which are coupled to **OUTPUT.**

With continuing reference to FIG. 3, the circuit **10** further includes third delay stage **60**, an inverter formed of **PMOS** transistor **M9** and **NMOS** transistor **M10. M9** has its gate coupled to the output of **IV1,** its source coupled to **Vcc,** and its drain, which is the output of stage **60**, is coupled to the drain of **M10. M10** has its gate coupled to the output of **IV1** and its source coupled to **GND.** The output of stage **60** is coupled to the control nodes of devices **20** and **30**. Specifically, device **20** is a **PMOS** transistor **M3** having its gate coupled to the output of stage **60,** and device **30** is an **NMOS** transistor **M4** also having its gate coupled to the output of stage **60**. Transistor **M3** is in parallel with pulldown transistor **M1** in that its drain is coupled to **GND** and its source is coupled to **OUTPUT.** Similarly, transistor **M4** is in parallel with pull-up transistor **M2** in that its drain is coupled to **Vcc** and its source is coupled to **OUTPUT.**

In operation, the circuit **10** of FIG. 3 changes an **OUTPUT** signal transition from logic H to logic L as follows. First, prior to the initiation of the transition when a static H is in effect, **INPUT** is at a logic H and **OUTPUT** is at a logic H. That is, **M1** and **M3** are off, and **M2** and **M4** are on. As **INPUT** switches from H to L, delay stage **60** first turns transistor **M3** on and transistor **M4** off while the **INPUT** signal is propagating through stages **40** and **50.** Transistor **M3** is preferably a relatively large PMOS transistor such that a substantial portion of the current at **OUTPUT** is quickly discharged to **GND**. As the current at **OUTPUT** is reduced, the potential at that node is also reduced. When it is approximately the same as the gate-to-source potential **Vgs** of transistor **M3,** that transistor turns off and the **OUTPUT** signal drive is substantially reduced. However, as the source potential for **M3** reduces, the drain potential of parallel pulldown transistor **M1** increases so as to cause a relatively slow and gradual turning on of that transistor and a relatively slow and gradual turning off of pull-up transistor **M2**. The gradual turning on of **M1** causes **OUTPUT** to coast to a logic low corresponding to the potential of **GND.**

The reduced drive that occurs at the end of the H-to-L transition substantially eliminates undershoot and overshoot of the logic level. In addition, the circuit **10**, which may be fabricated with relatively small NMOS transistors, reduces output switching noise when compared to prior-art output buffers that discharge at similar rates. It is to be noted with respect to the circuit **10** of FIG. 3 that a L-to-H transition can be accomplished in a similar manner. Also, while devices **20** and **30** are shown in the preferred embodiment as MOS transistors, the same variable drive may be achieved using other device configurations including, but not limited to, replacing transistor **M3** with a PNP-type bipolar transistor and transistor **M4** with an NPN-type bipolar transistor.

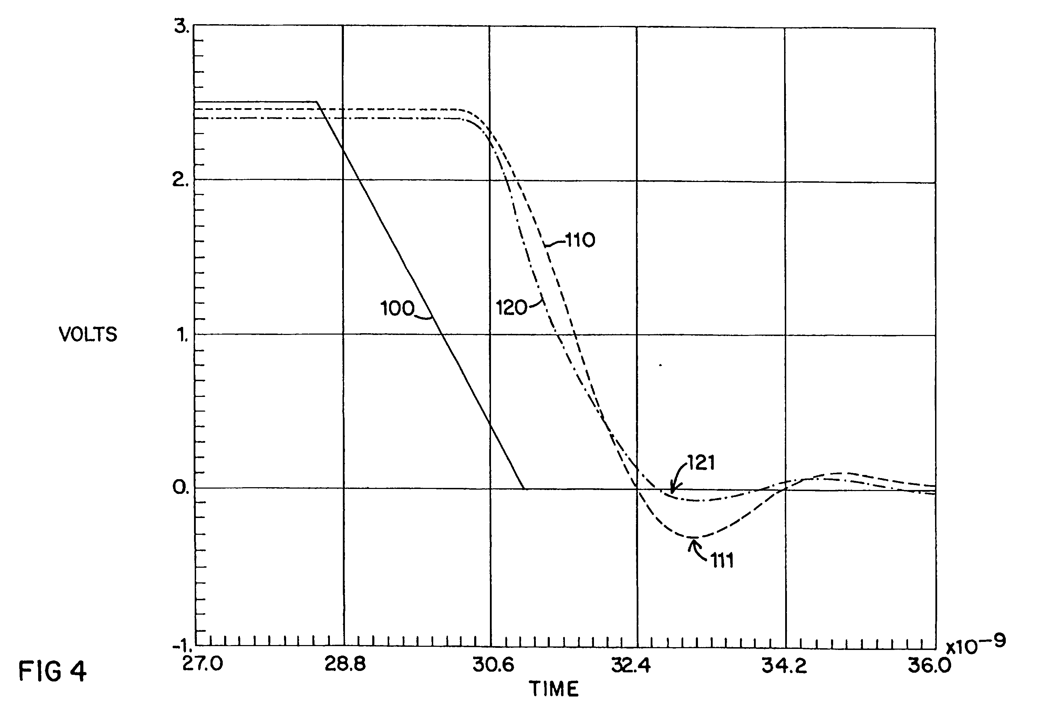

The advantage of the present invention as shown in FIG. 3 is clearly seen in the waveforms shown in FIG. 4. Specifically, for a H-to-L transition, input signal **100** changes from a potential associated with a logic H to a potential associated with a logic low. In the prior-art circuit of FIG. 1, a prior-art waveform **110** results and clearly can be seen at **111** to develop a significant undershoot. The circuit **10** of FIG. 3, on the other hand, provides a smooth transition as can be seen by waveform **120**, wherein undershoot at **121** is much less than that at **111**. It has been determined by simulation that the circuit **10** reduces undershoot by as much as 230 mV, overshoot by 70 mV, and provides a reduction in propagation delay of as much as 180 picoseconds.

While the present invention has been described with specific reference to particular embodiments, it is to be understood that all modifications, variants, and equivalents are deemed to be within the scope of the following appended claims.

## Claims

1. An output buffer for passing a logic signal from an input node to an output node, wherein said buffer is couplable between a high-potential power rail and a low-potential power rail, said buffer comprising:
a. a first driver stage having an input coupled to the input node and an output coupled to the output node; and
b. a second driver stage having an input coupled to the input node and a pull-up transistor and a pulldown transistor coupled to the output node,
wherein when the logic signal at the input node changes, said first driver stage is designed to substantially charge or discharge the output node prior to a switching on or off of either said pull-up transistor or said pulldown transistor.

2. The buffer as claimed in **Claim 1** wherein said first driver stage includes a first transition device coupled in parallel with said pulldown transistor and a second transition device coupled in parallel with said pull-up transistor.

3. The buffer as claimed in **Claim 2** wherein said first driver stage further includes a delay stage coupled between the input node and control nodes of said first transition device and said second transition device, and wherein said second driver stage includes a delay stage coupled between the input node and control nodes of said pull-up transistor and said pulldown transistor, wherein a propagation delay associated with said delay stage of said second driver stage is less than a propagation delay associated with said delay stage of said first driver stage.

4. The buffer as claimed in **Claim 2** wherein said first transition device is a PMOS transistor having a gate coupled to the input node, a source coupled to the output node, and a drain coupled to the low-potential power rail, and wherein said second transition device is an NMOS transistor having a gate coupled to the input node, a source coupled to the output node, and a drain coupled to the high-potential power rail.

5. The buffer as claimed in **Claim 4** wherein said first driver stage further includes a delay stage coupled between the input node and said gate of said PMOS transistor and said gate of said NMOS transistor, and wherein said second driver stage includes a delay stage coupled between the input node and control nodes of said pull-up transistor and said pulldown transistor, wherein a propagation delay associated with said delay stage of said second driver stage is less than a propagation delay associated with said delay stage of said first driver stage.

6. The buffer as claimed in **Claim 5** wherein said delay stage of said first driver stage is a single inverter and said delay stage of said second driver stage is a pair of inverters coupled together in series.

7. An output buffer for passing a logic signal from an input node to an output node, wherein said buffer is couplable between a high-potential power rail arid a low-potential power rail, and wherein said buffer reduces undershoot, overshoot, and switching noise during a logic high to logic low signal transition, said buffer comprising:
a. a first driver stage having an input coupled to the input node and an output coupled to the output node, wherein said first driver stage includes a transition device coupled between the output node and the low-potential power rail; and
b. a second driver stage having an input coupled to the input node, a pull-up transistor coupled between the high-potential power rail and the output node and a pulldown transistor coupled between the output node and the low-potential power rail,
wherein when the logic signal at the input changes from high to low, said transition device is designed to substantially discharge the output node prior to a switching on of said pulldown transistor.

8. The buffer as claimed in **Claim 7** wherein said transition device of said first driver stage is a PMOS transistor coupled in parallel with said pulldown transistor, wherein said PMOS transistor has a gate coupled to the input node, a source coupled to the output node, and a drain coupled to the low-potential power rail.

9. The buffer as claimed in **Claim 8** wherein said first driver stage further includes a delay stage coupled between the input node and said gate of said PMOS transistor, and wherein said second driver stage includes a delay stage coupled between the input node and control nodes of said pull-up transistor and said pulldown transistor, wherein a propagation delay associated with said delay stage of said second driver stage is less than a propagation delay associated with said delay stage of said first driver stage.

10. The buffer as claimed in **Claim 9** wherein said delay stage of said first driver stage is a single inverter and said delay stage of said second driver stage is a pair of inverters coupled together in series.

11. An output buffer for passing a logic signal from an input node to an output node, wherein said buffer is couplable between a high-potential power rail and a low-potential power rail, and wherein said buffer reduces undershoot, overshoot, and switching noise during a logic low to logic high signal transition, said buffer comprising:
a. a first driver stage having an input coupled to the input node and an output coupled to the output node, wherein said first driver stage includes a transition device coupled between the output node and the high-potential power rail; and
b. a second driver stage having an input coupled to the input node, a pull-up transistor coupled between the high-potential power rail and the output node and a pulldown transistor coupled between the output node and the low-potential power rail,
wherein when the logic signal at the input changes from low to high, said transition device is designed to substantially charge the output node prior to a switching on of said pull-up transistor.

12. The buffer as claimed in **Claim 11** wherein said transition device of said first driver stage is an NMOS transistor coupled in parallel with said pull-up transistor, wherein said NMOS transistor has a gate coupled to the input node, a source coupled to the output node, and a drain coupled to the high-potential power rail.

13. The buffer as claimed in **Claim 12** wherein said first driver stage further includes a delay stage coupled between the input node and said gate of said NMOS transistor, and wherein said second driver stage includes a delay stage coupled between the input node and control nodes of said pull-up transistor and said pulldown transistor, wherein a propagation delay associated with said delay stage of said second driver stage is less than a propagation delay associated with said delay stage of said first driver stage.

14. The buffer as claimed in **Claim 13** wherein said delay stage of said first driver stage is a single inverter and said delay stage of said second driver stage is a pair of inverters coupled together in series.
